# EUROPEAN PATENT APPLICATION

(11) **EP 1 315 231 A2**
(43) Date of publication of application: **28.05.2003**
(21) Application number: 02025909.9
(22) Date of filing: 20.11.2002
(51) Int. Cl.: H01P 7/10, C04B 35/462, H01G 4/30, H01G 4/12, C03C 14/00

(54) **Dielectric ceramic composition and laminated ceramic parts using the same**

(30) Priority: 21.11.2001 JP 2001355696; 21.11.2001 JP 2001355697; 12.04.2002 JP 2002110517; 12.04.2002 JP 2002110518
(71) Applicant: Ube Electronics, Ltd., Mine-shi, Yamaguchi (JP); Ube Industries, Ltd., Ube City, Yamaguchi (JP)
(72) Inventor: Kawano, Takafumi, c/o Ube Industries, Ltd., Ube-shi, Yamaguchi (JP); Fukuda, Koichi, c/o Ube Industries, Ltd., Ube-shi, Yamaguchi (JP)
(74) Representative: Gervasi, Gemma, Dr.

(57) **Abstract**

A dielectric ceramic composition contains a glass component in an amount of 5 to 150 parts by weight based on 100 parts by weight of the main component represented by the formula: xZn₂TiO₄-(1-x)ZnTiO₃-yTiO₂, wherein x satisfies 0<x<1 and y satisfies 0≤y≤0.5. The dielectric ceramic composition is sintered at a temperature of 800 to 1000°C where integration and lamination with a low resistant conductor such as Cu or Ag by the simultaneous sintering can be performed. The dielectric ceramic composition has a low dielectric loss tanδ (high Q-value), a small absolute value in temperature coefficient τᵣ of resonant frequency and a dielectric constant εᵣ on the order of 8 to 30 so as to form laminated ceramic parts and the like into an appropriate size.

## Description

### BACKGROUND OF THE INVENTION

### Field of the Invention:

The present invention relates to a dielectric ceramic composition which can be sintered simultaneously with Au, Ag, Cu or the like as a low resistant conductor and which is suitable for laminated ceramic parts because of its low dielectric loss (high Q-value); and laminated ceramic parts using the dielectric ceramic composition, such as a laminated ceramic capacitor and an LC filter. In particular, the present invention relates to a dielectric ceramic composition comprising a main component containing Zn₂TiO₄ and ZnTiO₃ and a glass component; and laminated ceramic parts using the composition. The main component may additionally contain TiO₂.

### Description of the Related Art:

In recent years, to keep up with the tendency toward integrated microwave circuits, demands for a compact dielectric resonator having a small dielectric loss (tanδ) and exhibiting stable dielectric properties are increasing. The dielectric ceramic composition used for such a dielectric resonator is demanded to have a relatively large dielectric constant εᵣ, a large unloaded Q-value and a small temperature coefficient τ_{f} of resonant frequency. In general, as the dielectric constant εᵣ is larger, the resonator can be more reduced in the size, and as the resonant frequency is higher, the resonator can also be more reduced in the size. However, if the resonator is excessively reduced in the size, processing precision decreases, printing precision of an electrode readily affects the dielectric properties and therefore, in a specific use, a dielectric ceramic composition having a suitable range in the dielectric constant εᵣ is demanded such that the resonator is not excessively reduced in the size. For example, it is preferable to use a dielectric ceramic composition having a dielectric constant εᵣ on the order of from 8 to 30 for the dielectric resonator.

For this type of dielectric ceramic composition, BaO-MgO-WO₃-base material (JP(A)6-236708), Al₂O₃-TiO₂-Ta₂O₅ base material (JP(A)9-52760) and the like have been proposed.

In recent years, laminated ceramic parts formed by laminating a dielectric ceramic composition, such as a laminated ceramic capacitor or an LC filter, have been developed and the lamination by the simultaneous sintering of a dielectric ceramic composition and an internal electrode is being performed. However, the above-described conventional dielectric ceramic compositions have a difficulty in performing the simultaneous sintering with the internal electrode because of their high sintering temperature of 1300 to 1400 °C and therefore, for forming a lamination structure, material of the internal electrode is limited to a high-temperature resistant material such as palladium (Pd) or platinum (Pt). For this reason, there has been demanded a dielectric ceramic composition capable of performing the simultaneous sintering with the internal electrode at a low temperature of 1000°C or less, using as the internal electrode material silver (Ag), Ag-Pd, Cu and the like, which are a low resistant conductor and inexpensive.

### SUMMARY OF THE INVENTION

The object of the present invention is to provide a dielectric ceramic composition which can be sintered at such a temperature of about 800 to 1000°C as to permit incorporation of and multilayer formation with a low resistant conductor such as Cu or Ag by the simultaneous sintering with the low resistant conductor and which has a low dielectric loss tanδ (high Q-value), a small absolute value in temperature coefficient τ_{f} of resonant frequency and a dielectric constant εᵣ on the order of 8 to 30 so as to form laminated ceramic parts and the like into an appropriate size. Another object of the present invention is to provide laminated ceramic parts such as a laminated ceramic capacitor or an LC filer, which have a dielectric layer comprising such a dielectric ceramic composition and an internal electrode mainly comprising Cu or Ag.

As a result of extensive investigations to solve the above-described problems in the conventional dielectric ceramic materials, the present inventors have found that the following composition satisfies the requirement for solving the problems.

According to the present invention, there is provided a dielectric ceramic composition characterized by containing a glass component in an amount of 5 to 150 parts by weight based on 100 parts by weight of the main component represented by the formula: xZn₂TiO₄-(1-x)ZnTiO₃-yTiO₂, wherein x satisfies 0<x<1 and y satisfies 0≤y≤0.5.

The glass component is preferably a PbO-base glass, a ZnO-base glass, a SiO₂-base glass or a glass comprising two or more metal oxides selected from the group consisting of PbO, ZnO, Bi₂O₃, BaO, B₂O₃, SiO₂, ZrO₂, TiO₂, Al₂O₃, CaO and SrO.

Furthermore, the dielectric ceramic composition may contain CuO in an amount of 40 parts by weight or less based on 100 parts by weight of the main component.

Also, the dielectric ceramic composition may contain MnO in an amount of 30 parts by weight or less based on 100 parts by weight of the main component.

According to the present invention, there is also provided a method of producing a dielectric ceramic composition characterized in that a calcined powder comprising Zn₂TiO₄ and ZnTiO₃ is prepared by calcining a first mixture of ZnO powder and TiO₂ powder, and sintering a second mixture of the calcined powder and a glass component in an amount of 5 to 150 parts by weight based on 100 parts by weight of the calcined powder at a temperature of 800 to 1000°C. The second mixture may contain TiO₂ powder. The second mixture may further contain CuO or MnO.

According to the present invention, there is also provided laminated ceramic parts characterized by comprising a plurality of dielectric layers, an internal electrode formed between the dielectric layers and an external electrode electrically connected to the internal electrode, wherein the dielectric layer is constituted of dielectric ceramics obtained by sintering the dielectric ceramic composition, and the internal electrode is made of elemental Cu or elemental Ag, or an alloy material mainly comprising Cu or Ag.

By preparing a specific composition comprising a main component or matrix material component containing Zn₂TiO₄ and ZnTiO₃ (TiO₂ may be added thereto) and a glass component, it can be attained that the sintering temperature is 1000°C or less, the dielectric constant εᵣ is on the order of from 8 to 30, the dielectric loss is small and the absolute value in a temperature coefficient of resonant frequency is 60 ppm/°C or less. And, by adding CuO or MnO as a side component, the sintertng temperature can be more lowered. By virtue of these characteristics, laminated ceramic parts having an internal electrode comprising elemental Cu or elemental Ag, or mainly comprising Cu or Ag, can be provided.

### BRIEF DESCRIPTION OF THE DRAWINGS

Fig. 1 is a perspective view showing one embodiment of the laminated ceramic parts according to the present invention;
Fig. 2 is a cross-sectional view of the embodiment of the laminated ceramic parts of Fig. 1;
Fig. 3 is an X-ray diffraction diagram of the sintered body of the dielectric ceramic composition according to the present invention; and
Fig. 4 is an X-ray diffraction diagram of the sintered body of the dielectric ceramic composition according to the present invention.

### DESCRIPTION OF THE PREFERRED EMBODIMENTS

A dielectric ceramic composition of the present invention will be described in detail below.

The dielectric ceramic composition of the present invention is characterized by containing a glass component in an amount of 5 to 150 parts by weight based on 100 parts by weight of the main component represented by the formula: xZn₂TiO₄-(1-x)ZnTiO₃-yTiO₂, wherein x satisfies 0<x<1 and y satisfies 0≤y≤0.5.

The composition wherein x satisfies 0<x<1 achieves the absolute value of temperature coefficient τ_{f} of resonant frequency of 60 ppm/°C or less, the dielectric constant εᵣ of 8 to 30 and high Qxf value, for example greater than 1500 GHz. It is preferable that x satisfies 0.02<x<0.98.

If y is more than 0.5, the composition is not preferable because τᵣ is more than +60 ppm/°C. In the dielectric ceramic composition of the present invention, if the glass component is contained in an amount of less than 5 parts by weight based on 100 parts by weight of the main component served as the ceramic matrix material, the sintering temperature becomes high, whereas if it is contained in excess of 150 parts by weight, the glass is liable to elute to react with a setter which is used in sintering. The glass component is preferably contained in an amount of 9 to 120 parts by weight based on 100 parts by weight of the main component.

The Zn₂TiO₄ for use in the present invention can be obtained by mixing zinc oxide (ZnO) and titanium oxide (TiO₂) in a molar ratio of 2:1 and calcining the mixture. The ZnTiO₃ can be obtained by mixing ZnO and TiO₂ in a molar ratio of 1:1 and calcining the mixture. As starting materials of Zn₂TiO₄ and ZnTiO₃, nitrate, carbonate, hydroxide, chloride and an organic metal compound each turning into an oxide of zinc or titanium at the time of calcining, may also be used, in addition to TiO₂ and ZnO.

The dielectric ceramic composition of the present invention is characterized by containing a glass component in a predetermined amount. The glass used herein as the glass component means an amorphous solid substance obtained by fusion. A crystallized glass partially containing a crystallized substance in a glass is also included in the glass. The solid substance includes an inorganic substance comprising an oxide and examples of the glass for use in the present invention include a PbO-base glass, a ZnO-base glass, a SiO₂-base glass and a glass comprising metal oxides. The PbO-base glass is a glass containing PbO, and examples thereof include a glass containing PbO-SiO₂, PbO-B₂O₃ or PbO-P₂O₅, or a glass containing R₂O-PbO-SiO₂, R₂O-CaO-PbO-SiO₂, R₂O-ZnO-PbO-SiO₂ or R₂O-Al₂O₃-PbO-SiO₂ (herein, R is Na Or K). The ZnO-base glass is a glass containing ZnO, and examples thereof include a glass containing ZnO-Al₂O₃-BaO-SiO₂ or ZnO-Al₂O₃-R₂O-SiO₂. The SiO₂-base glass is a glass containing SiO₂, and examples thereof include a glass containing SiO₂-Al₂O₃-R₂O or SiO₂-Al₂O₃-BaO.

As the glass for use in the present invention, in addition to the PbO-base glass, the ZnO-base glass and the SiO₂-base glass, a glass comprising various metal oxides can also be used, and examples thereof include a glass comprising two or more metal oxides selected from the group consisting of PbO, ZnO, Bi₂O₃, BaO, B₂O₃, SiO₂, ZrO₂, TiO₂, Al₂O₃, CaO and SrO. Either an amorphous glass or a crystalline glass may be used as the glass. If the glass contains PbO, the sintering temperature is liable to lower, however, the unloaded Q-value is liable to decrease and therefore, the content of the PbO component in the glass is preferably 40% by weight or less. A glass containing a SiO₂ component and an Al₂O₃ component in a glass at the same time (namely, SiO₂-Al₂O₃ base glass) is more preferably used as the glass for use in the present invention. In the present invention, ZnO-Al₂O₃-BaO-SiO₂ is most preferably used in that a high unloaded Q-value can be obtained.

According to the present invention, a glass component is incorporated in an amount of 5 to 150 parts by weight based on 100 parts by weight of the main component represented by the formula: xZn₂TiO₄-(1-x)ZnTiO₃-yTiO₂, wherein x satisfies 0<x<1 and y satisfies 0≤y≤0.5, whereby a dielectric ceramic composition having such characteristics that a low temperature sintering can be performed at the sintering temperature of 800 to 1000°C, the dielectric constant εᵣ is on the order of from 8 to 30, the unloaded Q-value is large, for example Qxf being 1500 GHz or more, and the absolute value of temperature coefficient τ_{f} of resonant frequency is 60 ppm/°C or less, can be obtained.

In the present invention, before the sintering, Zn₂TiO₄, ZnTiO₃, TiO₂ and glass particles are each independently pulverized and mixed with each other, or respective starting material particles are mixed and pulverized, and when these starting material particles before the sintering have an average particle size of less than 5 µm, preferably 1 µm or less, the sintering at a lower temperature can be performed. However, if the average particle size is excessively reduced, the treating may become difficult and therefore, the average particle size is preferably 0.05 µm or more.

In the present invention, further, CuO is incorporated into the dielectric ceramic composition as aside component to produce a dielectric ceramic composition containing a glass component in an amount of 5 to 150 parts by weight and CuO in an amount of 40 parts by weight or less, based on 100 parts by weight of the main component represented by the formula: xZn₂TiO₄-(1-x)ZnTiO₃-yTiO₂, wherein x satisfies 0<x<1 and y satisfies 0≤y≤0.5, whereby the sintering temperature can be more lowered without deteriorating various characteristics described above. If the CuO is incorporated in excess of 40 parts by weight based on 100 parts by weight of the main component, the composition is not preferable because τ_{f} is reduced to less than -60 ppm/°C. The CuO is preferably in an amount of 2.5 parts by weight or more based on 100 parts by weight of the main component.

In the present invention, also, MnO is similarly incorporated into the dielectric ceramic composition as a side component to produce a dielectric ceramic composition containing a glass component in an amount of 5 to 150 parts by weight and MnO in an amount of 30 parts by weight, based on 100 parts by weight of the main component represented by the formula: xZn₂TiO₄-(1-x)ZnTiO₃-yTiO₂, wherein x satisfies 0<x<1 and y satisfies 0≤y≤0.5, whereby the sintering temperature can be similarly lowered without deteriorating various properties described above. If the MnO is incorporated in excess of 30 parts by weight based on 100 parts by weight of the main component, the component is not preferable because the Q-value is reduced. The MnO is preferably in an amount of 2.5 parts by weight or more based on 100 parts by weight of the main component.

The CuO or the MnO, which is added as the side component, may be added individually or both of the components may be added in combination.

The production method of the dielectric ceramic composition of the present invention is described below.

The dielectric ceramic composition can be produced by preparing a calcined powder comprising Zn₂TiO₄ and ZnTiO₃ by calcination of a first mixture of ZnO powder and TiO₂ powder, and sintering a second mixture of the calcined powder and a glass component in an amount of 5 to 150 parts by weight based on 100 parts by weight of the calcined powder at a temperature of 800 to 1000°C. The second mixture may contain TiO₂ powder. The second mixture may further contain CuO in an amount of 40 parts by weight or less based on 100 parts by weight of the calcined powder. The second mixture may further contain MnO in an amount of 30 parts by weight or less based on 100 parts by weight of the calcined powder.

More detailed description will be provided hereinafter.

Titanium oxide (TiO₂) and zinc oxide (ZnO) are weighed in a predetermined molar ratio and wet-mixed together with a solvent such as water or an alcohol. Subsequently, after removing the water, the alcohol or the like, the resulting mixture is pulverized and calcined at from 900 to 1200°C on the order of from about 1 to 5 hours in an oxygen-containing atmosphere (for example, air atmosphere. The Zn₂TiO₄, ZnTiO₃ and a glass, and, if desired, TiO₂, CuO or MnO are weighed in a predetermined ratio and then, wet-mixed together with a solvent such as water or an alcohol. Subsequently, after removing the water, the alcohol or the like, the resulting mixture is pulverized to produce a starting material powder.

ZnTiO₃ is prepared as the starting material powder in case of the above predetermined molar ratio of TiO₂:ZnO=1:1, while Zn₂TiO₄ is prepared as the starting material powder in case of the above predetermined molar ratio of TiO₂:ZnO=1:2.

That is, titanium oxide (TiO₂) and zinc oxide (ZnO) are weighed in a molar ratio of 1:2 and wet-mixed together with a solvent such as water or an alcohol. Subsequently, after removing the water, the alcohol or the like, the resulting mixture is pulverized and calcined at from 900 to 1200°C on the order of from about 1 to 5 hours in an oxygen-containing atmosphere (for example, air atmosphere). The thus-obtained calcined powder is Zn₂TiO₄. Then, titanium oxide (TiO₂) and zinc oxide (ZnO) are weighed in a molar ratio of 1:1 to produce ZnTiO₃ by the same production method as in Zn₂TiO₄. The Zn₂TiO₄, ZnTiO₃ and a glass, and, if desired, TiO₂, CuO or MnO are weighed in a predetermined ratio and then, wet-mixed together with a solvent such as water or an alcohol. Subsequently, after removing the water, the alcohol or the like, the resulting mixture is pulverized to produce a starting material powder.

In case that the above predetermined molar ratio of TiO₂:ZnO is a value between 1:1 and 1:2, i.e. TiO₂:ZnO=1:Z (wherein Z satisfies 1<Z<2), ZnTiO₃ and Zn₂TiO₄ are simultaneously produced with a molar ratio (ZnTiO₃/Zn₂TiO₄) of (2-Z)/(Z-1). In this case, the ZnTiO₃ and Zn₂TiO₄ can be obtained simultaneously with desired ratio by one step calcination.

Instead of obtaining the ZnTiO₃ and Zn₂TiO₄ simultaneously with desired ratio by using the mixture of TiO₂ and ZnO with their predetermined amounts calculated in advance, the calcined powder of ZnTiO₃ and the calcined powder of Zn₂TiO₄ may be produced respectively and these calcined powders may be mixed with a glass, and, if desired, TiO₂, CuO or MnO.

The dielectric ceramic composition of the present invention is evaluated in a pellet form on the dielectric properties. Specifically, in the above-described starting material powder, an organic binder such as polyvinyl alcohol is mixed. The mixture is rendered uniform, dried and pulverized, followed by molding under pressure (pressure: on the order of from 100 to 1000 kg/cm²) into a pellet form. The molded product obtained is sintered at from 800 to 1000°C in an oxygen-containing gas atmosphere such as air atmosphere, whereby a pellet of dielectric ceramic composition where a Zn₂TiO₄ phase, a ZnTiO₃ phase and a glass phase are present together, can be obtained. A TiO₂ phase may be present in the pellet.

If desired, the dielectric ceramic composition is processed to a proper shape and size, formed to a sheet by the doctor blade method and laminated by using the sheet and electrodes, whereby the composition may be used as materials for various laminated ceramic parts. Examples of the laminated ceramic parts include a laminated ceramic capacitor, an LC filter, a dielectric resonator and a dielectric substrate.

The laminated ceramic parts of the present invention comprises a plurality of dielectric layers, an internal electrode formed between the dielectric layers and an external electrode electrically connected to the internal electrode, wherein the dielectric layer is constituted of dielectric ceramics obtained by sintering the dielectric ceramic composition and the internal electrode is made of elemental Cu or elemental Ag, or an alloy material mainly comprising Cu or Ag. The laminated ceramic parts of the present invention can be obtained by laminating the dielectric layers each containing the dielectric ceramic composition and a layer of elemental Cu, elemental Ag or an alloy material mainly comprising Cu or Ag, and simultaneously sintering them.

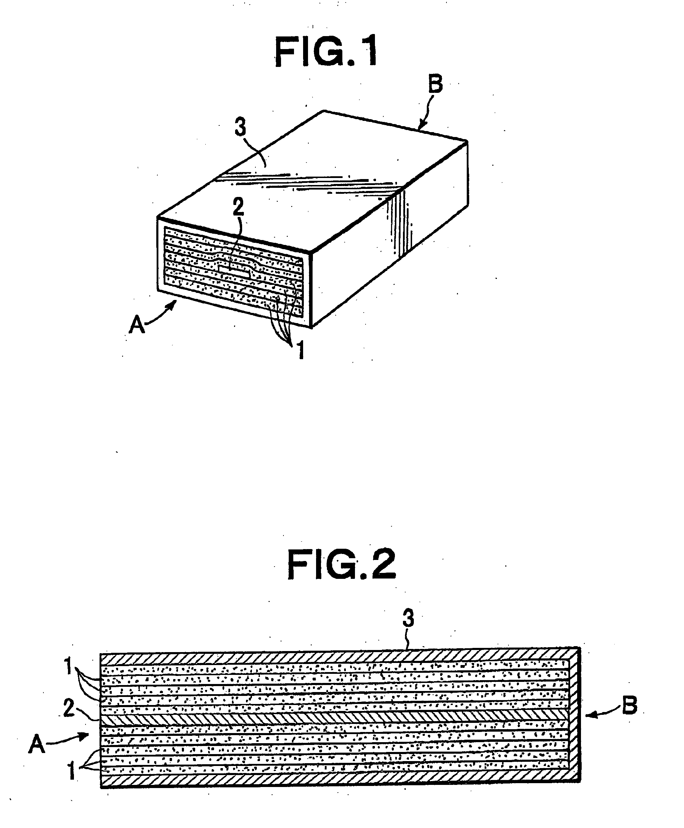

Examples of one embodiment of the laminated ceramic parts include a tri-plate type resonator shown in Figs. 1 and 2.

Fig. 1 is a perspective view showing the tri-plate type resonator as one embodiment according to the present invention, and Fig. 2 is a cross-sectional view of the resonator. As shown in Figs. 1 and 2, the tri-plate type resonator is laminated ceramic parts comprising a plurality of dielectric layers 1, an internal electrode 2 formed between the dielectric layers and an external electrode 3 electrically connected to the internal electrode. The internal electrode 2 is disposed at the center of the laminated dielectric layers 1. As shown in Figs. 1 and 2, the internal electrode 2 is formed so as to pass through the resonator from a first face A to a second face B opposing the first face A. The first face A is an open face, while the second face B is a closed face. That is, five faces of the resonator including the second face B exclusive of the first face A are covered by an external electrode 3, and the internal electrode 2 and the external electrode 3 are connected to each other on the second face B. The material of the internal electrode 2 comprises Cu or Ag, or mainly comprises Cu or Ag. When the dielectric ceramic composition of the present invention is used, the sintering can be performed at a low temperature and therefore, these materials for the internal electrode can be used.

### [Example 1]

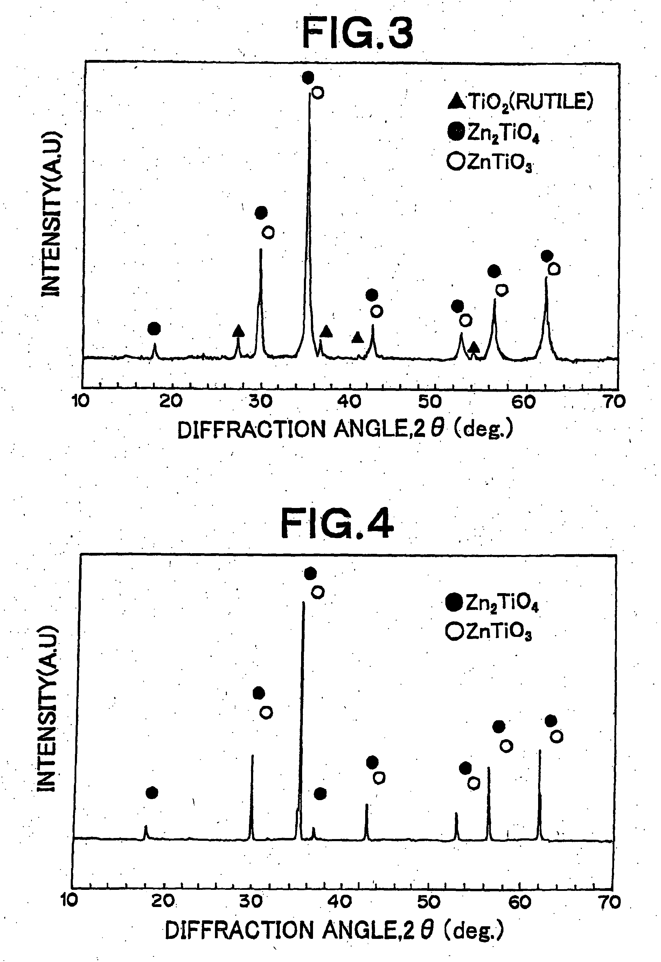

0.33 mol of titanium oxide (TiO₂) and 0.66 mol of zinc oxide (ZnO) were charged into a ball mill together with ethanol and wet-mixed for 12 hours. After removing the solvent from the solution, the resulting mixture was pulverized and calcined in an air atmosphere of 1000°C to obtain a Zn₂TiO₄ calcined powder. Then, 0.5 mol of TiO₂ and 0.5 mol of ZnO were wet-mixed and calcined in the same method to obtain a ZnTiO₃ calcined powder. The Zn₂TiO₄ calcined powder, the ZnTiO₃ calcined powder and TiO₂ powder were prepared in the blended amount shown in Table 1 to serve as a matrix material. To the matrix material, 10 parts by weight of a glass powder comprising 52% by weight of ZnO, 6% by weight of SiO₂, 12% by weight of Al₂O₃ and 30% by weight of B₂O₃ were added based on 100 parts by weight of the matrix material, and the mixture was charged into a ball mill, followed by wet-mixing for 24 hours. After removing the solvent from the solution, the resulting mixture was pulverized to an average particle size of 1 µm. To the pulverized product, an appropriate amount of a polyvinyl alcohol solution was added, followed by drying. Thereafter, the resulting pulverized product was molded into a pellet having a diameter of 12 mm and a thickness of 4 mm and the pellet obtained was sintered in an air atmosphere at 900°C for two hours. The X-ray diffraction diagram of the sintered body produced was shown in Fig. 3. As shown in Fig. 3, it is found that a Zn₂TiO₄ phase, a ZnTiO₃ phase and a TiO₂ phase are present together also in the sintered body of the dielectric ceramic composition of the present invention.

The thus-obtained dielectric ceramic composition was processed to a size of 7 mm in diameter and 3 mm in thickness and then, determined on the unloaded Q-value (Qxf) at the resonant frequency of 7 to 11 GHz, the dielectric constant εᵣ and the temperature coefficient τ_{f} of resonant frequency by the dielectric resonance method. The results thereof are shown in Table 2.

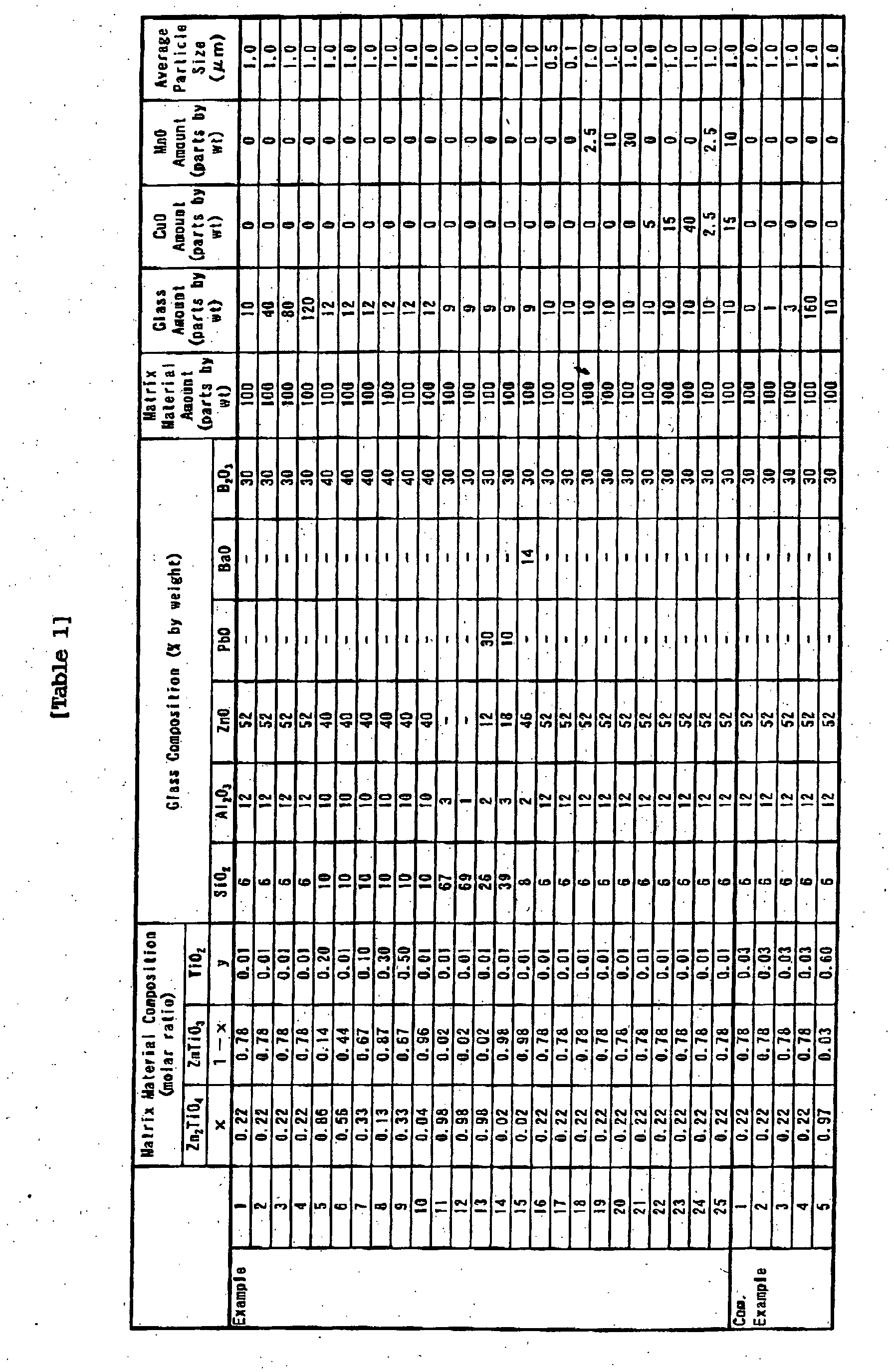

**[Table 2]**

| | | ε r | Q×f | τ f (ppm/°C) | Sintering Temp. (°C) |
|---|---|---|---|---|---|
| Example | 1 | 20 | 10000 | 0 | 900 |
| | 2 | 15 | 9000 | -20 | 840 |
| | 3 | 12 | 8000 | -30 | 840 |
| | 4 | 10 | 6000 | -30 | 840 |
| | 5 | 19 | 9000 | -10 | 900 |
| | 6 | 24 | 10000 | 56 | 900 |
| | 7 | 17 | 15000 | -15 | 900 |
| | 8 | 20 | 12000 | 0 | 900 |
| | 9 | 22 | 12000 | 60 | 900 |
| | 10 | 24 | 10000 | 46 | 900 |
| | 11 | 15 | 14700 | 4 | 900 |
| | 12 | 15 | 16500 | 12 | 900 |
| | 13 | 13 | 2000 | -60 | 840 |
| | 14 | 16 | 15000 | 14 | 900 |
| | 15 | 18 | 8000 | -60 | 900 |
| | 16 | 21 | 11000 | 0 | 850 |
| | 17 | 21 | 11500 | 0 | 800 |
| | 18 | 20 | 9000 | 6 | 880 |
| | 19 | 22 | 6000 | 15 | 850 |
| | 20 | 16 | 3000 | -40 | 830 |
| | 21 | 20 | 9000 | 0 | 880 |
| | 22 | 18 | 9000 | -30 | 850 |
| | 23 | 16 | 7000 | -40 | 830 |
| | 24 | 20 | 9000 | -30 | 850 |
| | 25 | 22 | 6000 | -5 | 850 |
| Com. Example | 1 | composition is not sintered at 1000°C or less | | | |
| | 2 | composition is not sintered at 1000°C or less | | | |
| | 3 | composition is not sintered at 1000°C or less | | | |
| | 4 | glass is eluted | | | |
| | 5 | 30 | 10000 | 80 | 900 |

Also, to 100 g of a mixture of the matrix material and the glass, 9 g of polyvinyl butyral as a binder, 6 g of dibutylphthalate as a plasticizer, and 60 g of toluene and 30 g of isopropyl alcohol both as a solvent were added to produce a green sheet having a thickness of 100 µm by the doctor blade method. Then, 22 layers of the green sheets were laminated by the thermo compression bonding of applying a pressure of 200 kg/cm² at a temperature of 65°C. At this time, a layer having been printed with Ag pattern as an internal electrode was disposed such that it was provided at the center in the thickness direction. After sintering the obtained laminated product at 900°C for two hours, an external electrode was formed to produce a tri-plate type resonator having a size of 4.9 mm in width, 1.7 mm in height and 8.4 mm in length.

The obtained tri-plate type resonator was evaluated on the unloaded Q-value at a resonant frequency of 2 GHz. As a result, the percentage of contraction or shrinkage was 19% at the sintering temperature of 900°C, the dielectric constant εᵣ was 21, the temperature coefficient τ_{f} of resonant frequency was 0 ppm/°C and the unloaded Q-value was 210. As such, when the dielectric ceramic composition according to the present invention was used, the tri-plate type resonator having excellent characteristics could be obtained.

### [Examples 2 to 15]

In the same manner as in Example 1, Zn₂TiO₄, ZnTiO₃ and TiO₂ were blended in the blended amount shown in Table 1 to serve as a matrix material. After blending the matrix material with various glass components in the blended amount shown in Table 1, pellet-form sintered bodies were produced under the same conditions as in Example 1 and evaluated on various properties in the same method as in Example 1. The results thereof are shown in Table 2.

### [Examples 16 and 17]

In the same manner as in Example 1, Zn₂TiO₄, ZnTiO₃ and TiO₂ were blended in the blended amount shown in Table 1 to serve as a matrix material. After blending the matrix material with various glass components in the blended amount shown in Table 1, the blends were pulverized till the particle sizes were reduced to the average particle size described in Table 1, pellet-form sintered bodies were produced under the same conditions as in Example 1 and evaluated on various properties in the same method as in Example 1. The results thereof are shown in Table 2.

### [Examples 18 to 20]

In the same manner as in Example 1, Zn₂TiO₄, ZnTiO₃ and TiO₂ were blended in the blended amount shown in Table 1 to serve as a matrix material. After blending the matrix material with MnO and various glass components in the blended amount shown in Table 1, pellet-form sintered bodies were produced under the same conditions as in Example 1 and evaluated on various properties in the same method as in Example 1. The results thereof are shown in Table 2.

### [Examples 21 to 23]

In the same manner as in Example 1, Zn₂TiO₄, ZnTiO₃ and TiO₂ were blended in the blended amount shown in Table 1 to serve as a matrix material. After blending the matrix material with CuO and various glass components in the blended amount shown in Table 1, pellet-form calcined bodies were produced under the same conditions as in Example 1 and evaluated on various properties in the same method as in Example 1. The results thereof are shown in Table 2.

### [Examples 24 and 25]

In the same manner as in Example 1, Zn₂TiO₄, ZnTiO₃ and TiO₂ were blended in the blended amount shown in Table 1 to serve as a matrix material. After blending the matrix material with MnO, CuO and various glasses described in Table 1 in the blended amount shown in Table 1, pellet-form sintered bodies were produced under the same conditions as in Example 1 and evaluated on various properties in the same method as in Example 1. The results thereof were shown in Table 2.

### [Comparative Examples 1 to 4]

In the same manner as in Example 1, Zn₂TiO₄, ZnTiO₃ and TiO₂ were blended in the blended amount shown in Table 1 to serve as a matrix material. After blending the matrix material and the glass described in Table 1 in the blended amount shown in Table 1, pellet-form sintered bodies were intended to be produced under the same conditions as in Example 1. However, when the conditions were such that the glass was added in an amount of less than 5 parts by weight based on 100 parts by weight of the matrix material, the sintering was not realized at 1000°C or less and the sintered bodies were rendered dense when the sintering temperature was elevated up to 1200°C. When the glass was added in excess of 150 parts by weight based on 100 parts by weight of the matrix material, the glass was eluted to react with the setter, as a result, preferable sintered bodies were not obtained. The results thereof are shown in Table 2.

### [Comparative Examples 5]

In the same manner as in Example 1, Zn₂TiO₄, ZnTiO₃ and TiO₂ were blended in the blended amount shown in Table 1 to serve as a matrix material. After blending the matrix material and the glass described in Table 1 in the blended amount shown in Table 1, pellet-form sintered body was produced under the same conditions as in Example 1. However, when the condition was such that the molar ratio y of the TiO₂ was 0.6, the temperature coefficient τ_{f} of resonant frequency was more than +60 ppm/°C. The results thereof are shown in Table 2.

### [Example 1']

0.45 mol of titanium oxide (TiO₂) and 0.55 mol of zinc oxide (ZnO) were charged into a ball mill together with ethanol and wet-mixed for 12 hours. After removing the solvent from the solution, the resulting mixture was pulverized and calcined in an air atmosphere of 1000°C to obtain a matrix material. To the matrix material, 10 parts by weight of a glass powder comprising 52% by weight of ZnO, 6% by weight of SiO₂, 12% by weight of Al₂O₃ and 30% by weight of B₂O₃ were added based on 100 parts by weight of the matrix material, and the mixture was charged into a ball mill, followed by wet-mixing for 24 hours. After removing the solvent from the solution, the resulting mixture was pulverized to an average particle size of 1 µm. To the pulverized product, an appropriate amount of a polyvinyl alcohol solution was added, followed by drying. Thereafter, the resulting pulverized product was molded into a pellet having a diameter of 12 mm and a thickness of 4 mm and the pellet obtained was sintered in an air atmosphere at 900°C for two hours. The X-ray diffraction diagram of the sintered body produced was shown in Fig. 4. As shown in Fig. 4, it is found that a Zn₂TiO₄ phase and a ZnTiO₃ phase are present together in the sintered body of the dielectric ceramic composition of the present invention.

The thus-obtained dielectric ceramic composition was processed to a size of 7 mm in diameter and 3 mm in thickness and then, determined on the unloaded Q-value (Qxf) at the resonant frequency of 7 to 11 GHz, the dielectric constant εᵣ and the temperature coefficient τ_{f} of resonant frequency by the dielectric resonance method. The results thereof are shown in Table 4.

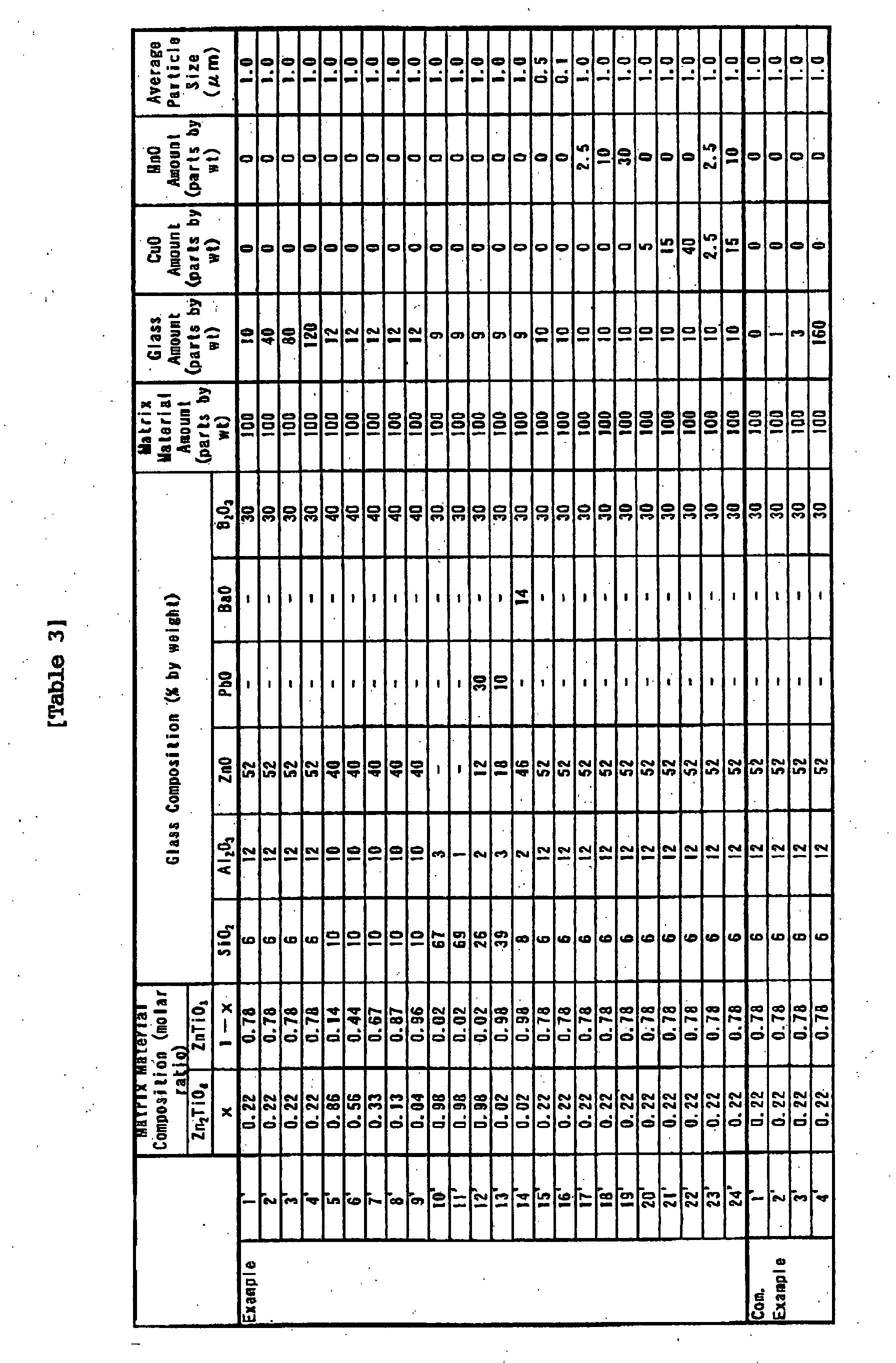

**[Table 4]**

| | | ε r | Q×f | τf (ppm/°C) | Sintering Temp. (°C) |
|---|---|---|---|---|---|
| Example | 1' | 20 | 10000 | 0 | 900 |
| | 2' | 15 | 7000 | -20 | 840 |
| | 3' | 12 | 6000 | -30 | 840 |
| | 4' | 10 | 14000 | -30 | 840 |
| | 5' | 16 | 15000 | -60 | 900 |
| | 6' | 17 | 12000 | -58 | 900 |
| | 7' | 19 | 11000 | -20 | 900 |
| | 8' | 19 | 10000 | 24 | 900 |
| | 9' | 22 | 10000 | 45 | 900 |
| | 10' | 24 | 15000 | 4 | 900 |
| | 11' | 15 | 16000 | 12 | 900 |
| | 12' | 15 | 1500 | -53 | 840 |
| | 13' | 19 | 3000 | -60 | 900 |
| | 14' | 18 | 13000 | -58 | 900 |
| | 15' | 20 | 11000 | 0 | 850 |
| | 16' | 21 | 11500 | 0 | 800 |
| | 17' | 20 | 9000 | 5 | 880 |
| | 18' | 22 | 6000 | 13 | 850 |
| | 19' | 16 | 3000 | -42 | 830 |
| | 20' | 20 | 9000 | -1 | 880 |
| | 21' | 18 | 9000 | -31 | 850 |
| | 22' | 16 | 7000 | -42 | 830 |
| | 23' | 20 | 9000 | -32 | 850 |
| | 24' | 22 | 6000 | -7 | 850 |
| Com. Example | 1' | composition is not sintered at 1000°C or less | | | |
| | 2' | composition is not sintered at 1000°C or less | | | |
| | 3' | composition is not sintered at 1000°C or less | | | |
| | 4' | glass is eluted | | | |

Also, to 100 g of a mixture of the matrix material and the glass, 9 g of polyvinyl butyral as a binder, 6 g of dibutylphthalate as a plasticizer, and 60 g of toluene and 30 g of isopropyl alcohol both as a solvent were added to produce a green sheet having a thickness of 100 µm by the doctor blade method. Then, 22 layers of the green sheets were laminated by the thermo compression bonding of applying a pressure of 200 kg/cm² at a temperature of 65°C. At this time, a layer having been printed with Ag pattern as an internal electrode was disposed such that it was provided at the center in the thickness direction. After sintering the obtained laminated product at 900°C for two hours, an external electrode was formed to produce a tri-plate type resonator having a size of 4.9 mm in width, 1.7 mm in height and 8.4 mm in length.

The obtained tri-plate type resonator was evaluated on the unloaded Q-value at a resonant frequency of 2 GHz. As a result, the percentage of contraction or shrinkage was 19% at the sintering temperature of 900°C, the dielectric constant εᵣ was 21, the temperature coefficient τ_{f} of resonant frequency was 0 ppm/°C and the unloaded Q-value was 210. As such, when the dielectric ceramic composition according to the present invention was used, the tri-plate type resonator having excellent characteristics could be obtained.

### [Examples 2' to 14']

In the same manner as in Example 1' ,TiO₂ and ZnO were blended and calcined so that the calcined powders of Zn₂TiO₄ and ZnTiO₃ were obtained in the blended amount shown in Table 3 after the calcination. After blending the calcined powders used as the matrix material with various glass components in the blended amount shown in Table 3, pellet-form sintered bodies were produced under the same conditions as in Example 1' and evaluated on various properties in the same method as in Example 1' . The results thereof are shown in Table 4.

### [Examples 15' and 1 6']

In the same manner as in Example 1' ,TiO₂ and ZnO were blended and calcined so that the calcined powders of Zn₂TiO₄ and ZnTiO₃ were obtained in the blended amount shown in Table 3 after the calcination. After blending the calcined powders used as the matrix material with various glass components in the blended amount shown in Table 3, the blends were pulverized till the particle sizes were reduced to the average particle size described in Table 3, pellet-form sintered bodies were produced under the same conditions as in Example 1' and evaluated on various properties in the same method as in Example 1'. The results thereof are shown in Table 4.

### [Examples 17' to 19']

In the same manner as in Example 1' , Zn₂TiO₄ and ZnTiO₃ were blended in the blended amount shown in Table 3 to serve as a matrix material. After blending the matrix material with MnO and various glass components in the blended amount shown in Table 3, pellet-form sintered bodies were produced under the same conditions as in Example 1' and evaluated on various properties in the same method as in Example 1' . The results thereof are shown in Table 4.

### [Examples 20' to 22']

In the same manner as in Example 1' , Zn₂TiO₄ and ZnTiO₃ were blended in the blended amount shown in Table 3 to serve as a matrix material. After blending the matrix material with CuO and various glass components in the blended amount shown in Table 3, pellet-form sintered bodies were produced under the same conditions as in Example 1' and evaluated on various properties in the same method as in Example 1' . The results thereof are shown in Table 4.

### [Examples 23' and 24']

In the same manner as in Example 1' , Zn₂TiO₄ and ZnTiO₃ were blended in the blended amount shown in Table 3 to serve as a matrix material. After blending the matrix material with MnO, CuO and various glass components in the blended amount shown in Table 3, pellet-form sintered bodies were produced under the same conditions as in Example 1' and evaluated on various prperties in the same method as in Example 1' . The results thereof are shown in Table 4.

### [Comparative Examples 1' to 4 ' ]

In the same manner as in Example 1' , Zn₂TiO₄ and ZnTiO₃ were blended in the blended amount shown in Table 3 to serve as a matrix material. After blending the matrix material and the glass described in Table 3 in the blended amount shown in Table 3, pellet-form sistered bodies were intended to be produced under the same conditions as in Example 1' . However, when the conditions were such that the glass was added in an amount of less than 5 parts by weight based on 100 parts by weight of the matrix material, the sintertng was not realized at 1000°C or less and the sintered bodies were rendered dense when the sintering temperature was elevated up to 1200°C. When the glass was added in excess of 150 parts by weight based on 100 parts by weight of the matrix material, the glass was eluted to react with the setter, as a result, preferable sintered bodies were not obtained. The results thereof are shown in Table 4.

According to the dielectric ceramic composition of the present invention, a dielectric ceramic composition can be provided such that the dielectric constant εᵣ is from 8 to 30, the unloaded Q-value is large, and the absolute value of temperature coefficient τ_{f} of resonant frequency is as small as 60 ppm/°C or less. Also, the dielectric ceramic composition can be sintered at a temperature of 1000°C or less and therefore, can be reduced in the electric power cost required for the sintering and moreover, can be sintered simultaneously with a low resistant conductor comprising elemental Cu or elemental Ag, or an alloy material mainly comprising Cu or Ag, so that laminated parts using the low resistant conductor as the internal electrode can be further provided.

## Claims

1. A dielectric ceramic composition containing a glass component in an amount of 5 to 150 parts by weight based on 100 parts by weight of a main component represented by the formula: xZn₂TiO₄-(1-x)ZnTiO₃-yTiO₂, wherein x satisfies 0<x<1 and y satisfies 0≤y≤0.5.

2. The dielectric ceramic composition as claimed in claim 1, wherein said glass component is at least one selected from a PbO-base glass. a ZnO-base glass, a SiO₂-base glass, and a glass comprising two or more metal oxides selected from the group consisting of PbO, ZnO, Bi₂O₃, BaO, B₂O₃, SiO₂, ZrO₂, TiO₂, Al₂O₃, CaO and SrO.

3. The dielectric ceramic composition as claimed in claim 1, which contains CuO in an amount of 40 parts by weight or less based on 100 parts by weight of said main component.

4. The dielectric ceramic composition as claimed in claim 1, which contains MnO in an amount of 30 parts by weight or less based on 100 parts by weight of said main component.

5. A method of producing a dielectric ceramic composition claimed in any one of claims 1 to 4, comprising:
preparing a calcined powder comprising Zi₂TiO₄ and ZnTiO₃ by sintering of a first mixture of ZnO powder and TiO₂ powder; and
sintering a second mixture of the calcined powder and a glass component in an amount of 5 to 150 parts by weight based on 100 parts by weight of the calcined powder at a temperature of 800 to 1000°C.

6. Laminated ceramic parts comprising a plurality of dielectric layers, an internal electrode formed between said dielectric layers, and an external electrode electrically connected to said internal electrode, wherein each of said dielectric layers is constituted of dielectric ceramics obtained by sintering the dielectric ceramic composition claimed in any one of claims 1 to 4, and said internal electrode is made of elemental Cu or elemental Ag, or an alloy material mainly comprising Cu or Ag.
